# EUROPEAN PATENT APPLICATION

(11) **EP 4 749 896 A1**
(43) Date of publication of application: **27.05.2026**
(21) Application number: 24215370.8
(22) Date of filing: 26.11.2024
(51) Int. Cl.: H02M 1/00, H01F 17/00, H05K 1/16

(54) **COMMON MODE CHOKE, AND SEMICONDUCTOR ARRANGEMENT COMPRISING THE COMMON MODE CHOKE**

(71) Applicant: ABB Schweiz AG, 5400 Baden (CH)
(72) Inventor: Hartmann, Samuel, 5603 Staufen (CH); Mazur, Marcin, 5417 Untersiggenthal (CH)
(74) Representative: Sykora & König Patentanwälte PartG mbB

(57) **Abstract**

A common mode choke (50, 52, 54, 56) is provided. The common mode choke comprises: a printed circuit board (40, 42); a first conductor path (66) on or within the printed circuit board (40, 42); and a second conductor path (68) on or within the printed circuit board (40, 42) underneath the first conductor path (66), wherein the second conductor path (68) is electrically isolated against the first conductor path (66), the second conductor path (68) follows the first conductor path (66), each of the conductor paths (66, 68) forms at least two coils (80, 82, 84, 86), and each conductor path (66, 68) has a clockwise orientation in at least one of its coils (80, 82, 84, 86), and the same conductor path (66, 68) has a counter-clockwise orientation in the other one of its coils (80, 82, 84, 86).

## Description

### FIELD OF THE INVENTION

The invention relates to the field of semiconductor arrangements with common mode chokes. In particular, the invention relates to a common mode choke for a semiconductor arrangement, and to the semiconductor arrangement having the common mode choke.

### BACKGROUND OF THE INVENTION

A semiconductor arrangement may comprise one or more semiconductor modules, with each of the semiconductor modules having at least one, preferably two or more active semiconductor switches, e.g., IGBTs or MOSFETS, and one or more passive semiconductor switches, e.g., diodes. In the following, the active semiconductor switches are simply referred to as semiconductor switches only and the passive semiconductor switches are simply referred to as diodes only. The semiconductor modules may be electrically arranged in parallel within the semiconductor arrangement. When paralleling the semiconductor modules, two or more of the semiconductor modules may be controlled by one gate driver. An output of the gate driver may be connected to gates and auxiliary emitters of the semiconductor switches of the semiconductor modules, e.g., of all semiconductor switches and/or of all semiconductor modules.

In this case, the gate driver may apply a voltage between the gates and the corresponding auxiliary emitters. In the result, currents may flow from the auxiliary emitters of the semiconductor switches via the gate driver to the gates of the semiconductor switches. However, gate- and/or emitter conductor tracks are typically close together to have low inductance. Since the gate and emitter currents have opposite direction in these conductor tracks, these currents normally are differential mode currents.

Beside this in general intended differential mode currents, there may be one or more common mode currents. For example, when the semiconductor switches have diodes electrically arranged in parallel with the semiconductor switches and some of the semiconductor switches are turned on, at some point the diodes of some others of the semiconductor switches may start to block. Typically one of the diodes blocks earlier than the others and a voltage builds up over the corresponding diode. This voltage then may drive currents, in particular common mode currents, through the semiconductor arrangement. This common mode currents may flow about half/half in gate conductor tracks and in the emitter conductor tracks. The common mode current in the gate tracks however may lead to a discharging of the gate of one or more of the semiconductor switches and to a charging of the gates of the other semiconductor switches. This unwanted charging and discharging may destabilize the switching operations. For example, one or more of the semiconductor switches may be unintentionally and temporarily turned off during the switching operations which may cause chaotic currents and voltage waveforms.

It is known to suppress these common mode currents by one or more common mode chokes (CMCs) for having well balanced currents within the semiconductor arrangement, in particular between the semiconductor modules. To this end, it is known to arrange commercially available CMCs on a Printed Circuit Board (PCB), which may be an adapter board of the semiconductor arrangement, that distribute the gate signals to the paralleled modules. Such known CMCs on top of a PCB may consist of a magnetic core, e.g., a ferrite ring core and two coils wound around it, with each coil being provided by one conductor path. An electro-magnetic coupling between these coils results in a low inductance for differential mode currents and a high inductance for common mode currents. However, the magnetic cores of these CMCs show hysteresis and saturation behavior. Therefore, it may happen that common mode inductances of the CMCs drop to very low values. In that case, switching curves of the switching operations cannot be stabilized anymore.

In addition, commercially available CMCs are an additional cost factor for a producer of the semiconductor arrangements and their availability has to be considered when producing the semiconductor arrangements, while complicating the supply chain. Even when having two commercially available CMCs of the same type, the inductance can vary from CMC to CMC which may lead to the switching imbalance. Furthermore, the behavior of the commercially available CMCs may depend on the magnetization current state of the core. It may not behave in the same way in a double pulse test and during real operation. The core can saturate, and the CMC may lose its high common mode inductance in a strong imbalance situation. In the most cases, the magnetic behavior of the core of the CMC is not specified by their manufacturers and it might change without any notice.

### DESCRIPTION OF THE INVENTION

It is an objective of the present invention to provide a Common Mode Choke (CMC), in particular for a semiconductor arrangement, which may enable to provide a cost-efficient semiconductor arrangement, which may enable to simplify a supply chain for producing the semiconductor arrangement, which may enable to simplify a qualification of the semiconductor arrangement, and/or which may contribute to keep inductance tolerances of the CMC low.

This objective is achieved by the subject-matter of the independent claims. Further exemplary embodiments are evident from the dependent claims and the following description.

A first aspect relates to a common mode choke. The common mode choke comprises: a printed circuit board; a first conductor path on or within the printed circuit board; and a second conductor path on or within the printed circuit board underneath the first conductor path, wherein the second conductor path is electrically isolated against the first conductor path, the second conductor path follows the first conductor path, each of the conductor paths forms at least two coils, and each conductor path has a clockwise orientation in at least one of its coils, and the same conductor path has a counter-clockwise orientation in the other one of its coils.

A second aspect relates to a semiconductor arrangement. The semiconductor arrangement comprises: at least one common mode choke as described in the foregoing paragraph and in the following description; a first semiconductor switch having a first electrical contact and at least a second electrical contact of the first semiconductor switch, wherein the first conductor path of the common mode choke is electrically coupled to the first electrical contact of the first semiconductor switch and the second conductor path of the common mode choke is electrically coupled to the second electrical contact of the first semiconductor switch; and at least a second semiconductor switch having a first electrical contact and at least a second electrical contact of the second semiconductor switch, wherein the first conductor path of the common mode choke is electrically coupled to the first electrical contact of the second semiconductor switch and thereby electrically couples the first electrical contact of the first semiconductor switch with the first electrical contact of the second semiconductor switch, and wherein the second conductor path of the common mode choke is electrically coupled to the second electrical contact of the first semiconductor switch and thereby electrically couples the second electrical contact of the first semiconductor switch with the second electrical contact of the second semiconductor switch. It has to be understood that some features of the present invention are described with respect to one of the aspects only for conciseness reasons and to avoid unnecessary repetitions, but that these features may be easily transferred to one or more of the other aspects by the person skilled in the art.

The solution according to the invention is a conductor layout of the adapter board PCB that implements a common mode choke. This PCB multi-layer spiral structure replaces commercial CMCs which safes cost, simplifies supply chain and qualification. Furthermore this PCB integrated CMC has no saturable ferrite core with hysteresis which makes the switching behaviour more predictable. Also, the inductance tolerances of the PCB integrated CMC is lower.

That the second conductor path follows the first conductor path may mean that the conductor paths are parallel to each other, in particular over their whole length or at least over the lengths of the coils. That the conductor paths are parallel to each other may mean that a distance between the conductor paths stays the same, e.g., over the lengths of the coils and/or over the lengths of the whole conductor paths. Alternatively or additionally, that the second conductor path follows the first conductor path may mean that a structure and/or form of the second conductor path corresponds to a structure and/or, respectively, form of the first conductor path. Alternatively or additionally, that the second conductor path follows the first conductor path may mean that from a top view on the horizontally oriented PCB the second conductor path is nearly completely covered by the first conductor path and/or that from a top view on the horizontally oriented conductor paths the form and/or structure of the conductor paths are nearly the same. That the second conductor path is "nearly completely" covered by the first conductor path from a top view may mean that, when seen from the top view, the first conductor path overlaps the second conductor path such that more than 80%, e.g., more than 90%, e.g., more than 95% of the whole area of the second conductor path is overlapped and thereby covered by the first conductor path, at least in the region of the coils.

That the second conductor path is arranged "underneath" the first conductor path means that, when the PCB is oriented horizontally such that an upper main plain of the PCB faces upwards and that a lower main plain of the PCB opposite to the upper main plain faces downwards, the first conductor path is formed and/or arranged above the second conductor path.

Each of the conductor paths may be embodied as electrically conductive line or via. The conductor paths may be embedded within the PCB or may be arranged and/or formed, e.g., printed, on the PCB. For example, a first conductive layer may be formed on one side of an insulation layer and a second conductive layer may be formed on another side of the insulation layer, and the first conductor path may be formed by the first conductive layer, e.g., by etching, and the second conductor path may be formed by the second conductive layer, e.g., by etching. The insulation layer and the conductive layers may form the PCB, in particular a first level of the PCB. The first conductive layer may be referred to as outer layer of the PCB and the second conductive layer may be an inner layer of the PCB. In addition, the PCB may have a second level underneath the first level, with the second level having a second insulation layer, a first conductive layer above the second insulation layer, and a second conductive layer underneath the second insulation layer.

It has to be mentioned that, as used in the present description, an orientation of one of the coils may not correspond to an orientation of the corresponding conductor path. In particular, the orientation of the coils exclusively refers to their physical form and may be clockwise or counterclockwise starting from a middle of the corresponding coil and extending to an outside of the corresponding coil. In contrast, the orientation of the conductor path exclusively refers to an orientation of the current flow direction through the corresponding coils. Therefore, when having a coil being oriented clockwise, for example, the conductor path is also clockwise when the current flows from the middle of the coil to an outside of the coil and the conductor path is oriented counterclockwise when the current flows from the outside of the coil to the middle of the coil. In contrast, when having a coil being oriented counterclockwise, the conductor path is also counterclockwise oriented when the current flows from the middle of the coil to the outside of the coil and the conductor path is clockwise oriented when the current flows from the outside of the coil to the middle of the coil. So, the orientation of the coils depends on their physical structure only, whereas the orientation of the conductor paths depends on the physical structure of the coils through which the current flows and on a direction of the corresponding current flow, i.e., from outside to the centre or from the centre to the outside of the corresponding coil.

The printed circuit board may be an adapter board of the semiconductor arrangement or may be a component of the adapter board. The adapter board may be used to couple one or more semiconductor switches, e.g., IGBTs, and/or one or more semiconductor modules to each other and/or to one or more corresponding gate drivers for controlling the semiconductor switches.

According to an embodiment, the printed circuit board comprises at least a first level, and the two coils of each of the conductor paths are formed within the first level. This may contribute to a simple configuration of the CMC. This may enhance the manufacturability of the common mode choke.

According to an embodiment, the first level comprises a first conductive layer and at least a second conductive layer arranged underneath the first conductive layer, the first conductor path is formed by the first conductive layer of the first level, and the second conductor path is formed by the second conductive layer of the first level. This may contribute to a simple configuration of the CMC. The first conductive layer may be the above-mentioned outer layer and the second conductive layer may be the above-mentioned inner layer.

According to an embodiment, each conductor path forms at least four coils, and the four coils of the conductor paths are formed within the first level. In particular, the four coils of the first conductor path may be formed by the first conductive layer of the first level and the four coils of the second conductor path may be formed by the second conductive layer of the first level. This may contribute to a very good suppression of the common mode currents.

According to an embodiment, each conductor path forms at least four coils, the printed circuit board comprises at least a second level underneath the first level, two of the four coils of one of the conductor paths are formed within the first level, and the other two coils of the same conductor path are formed within the second level. This may contribute to a very good suppression of the common mode currents while saving space. So, each conductor path may extend over two different levels of the PCB. The second level may comprise the first conductive layer of the second level and the second conductive layer of the second level. The first conductor path may be formed by the first conductive layer of the second level and the second conductor path may be formed by the second conductive layer of the second level.

According to an embodiment, each conductor path forms at least eight coils, four coils of one of the conductor paths are formed within the first level, and the other four coils of the same conductor path are formed within the second level. For example, four coils of the first conductor path may be formed by the first conductive layer of the first level and the other four coils of the first conductor path may be formed by the first conductive layer of the second level. Similarly, four coils of the second conductor path may be formed by the second conductive layer of the first level and the other four coils of the second conductor path may be formed by the second conductive layer of the second level. This may contribute to a very good suppression of the common mode currents.

According to an embodiment, in case of each of the conductor paths comprising four coils in one level, these four coils are arranged in form of a 2x2 matrix, the conductor paths in the coils in form of the 2x2 matrix arranged on the same diagonal have the same orientation. This may reduce effects of the exposure of the common mode choke to external magnetic fields.

According to an embodiment, the conductor paths are formed and/or arranged such that each of the conductor paths changes the level of the printed circuit board after the first coil and then after every second one of the coils. This may enable a simple layout of the PCB and thereby to keep the manufacturing costs low.

According to an embodiment, the conductor paths have the same orientation in two of their coils being arranged underneath each other. This may contribute to a very good suppression of the common mode currents.

According to an embodiment, the semiconductor arrangement comprises at least one gate driver for driving the first semiconductor switch, wherein the gate driver is electrically coupled with the first and/or second semiconductor switches by the common mode choke. In particular, the gate driver may be electrically coupled with the first semiconductor switch via the gate driver being electrically coupled to the conductor paths of the common mode choke and via the conductor paths of the common mode choke being electrically coupled to the electrical contacts of the first semiconductor switch. This may contribute to a very good suppression of the common mode currents between the gate driver and the first semiconductor switch.

According to an embodiment, the semiconductor arrangement comprises: a first semiconductor module having the first semiconductor switch and a third semiconductor switch; and a second semiconductor module having the second semiconductor switch and a fourth semiconductor switch, wherein the third semiconductor switch is electrically coupled to the fourth semiconductor switch by another common mode choke, wherein a structure of the other common mode choke may correspond to the structure of the common mode choke described in the foregoing. This may contribute to a very good suppression of the common mode currents between the first and second semiconductor switches. In particular, the second semiconductor switch may have a first electrical contact and a second electrical contact and the first semiconductor module may be electrically coupled to the second semiconductor module via the common mode choke by the first electrical contact of the first semiconductor switch being electrically coupled to the first electrical contact of the second semiconductor switch via the first conductor path and the second electrical contact of the first semiconductor switch being electrically coupled to the second electrical contact of the second semiconductor switch via the second conductor path. Optionally, the first semiconductor module may be electrically coupled to the second semiconductor module by two of the common mode chokes, wherein these two common mode chokes may be electrically arranged in series.

Alternatively, the first semiconductor module may be electrically coupled to the second semiconductor module by four of the common mode chokes, wherein the first semiconductor switch of the first semiconductor module and the second semiconductor switch of the second semiconductor module may be electrically coupled by two common mode chokes being electrically arranged in a first series, wherein a third semiconductor switch of the first semiconductor module and a fourth semiconductor switch of the second semiconductor module may be electrically coupled by another two common mode chokes being electrically arranged in a second series, and wherein the first series of common mode chokes may be electrically arranged in parallel to the second series of common mode chokes.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 shows an electric circuit diagram of an exemplary embodiment of a semiconductor arrangement;
Fig. 2 shows a side view of a first level of an exemplary embodiment of a printed circuit board of the semiconductor arrangement of figure 1;
Fig. 3 shows a top view on two coils of an exemplary embodiment of a conductor path of the semiconductor arrangement of figure 1;
Fig. 4 shows a top view on four coils of an exemplary embodiment of a conductor path of the semiconductor arrangement of figure 1;
Fig. 5 shows a side view of the first level and a second level of an exemplary embodiment of a printed circuit board of the semiconductor arrangement of figure 1;
Fig. 6 shows a perspective view of an exemplary embodiment of two conductor paths of the semiconductor arrangement of figure 1;
Fig. 7 shows a perspective view of one of the conductor paths of figure 6;
Fig. 8 shows a top view of an exemplary embodiment of conductor paths of the semiconductor arrangement of figure 1;
Fig. 9 shows a top view of an exemplary embodiment of conductor paths of the semiconductor arrangement of figure 1;
Fig. 10 shows a top view of an exemplary embodiment of conductor paths of the semiconductor arrangement of figure 1.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

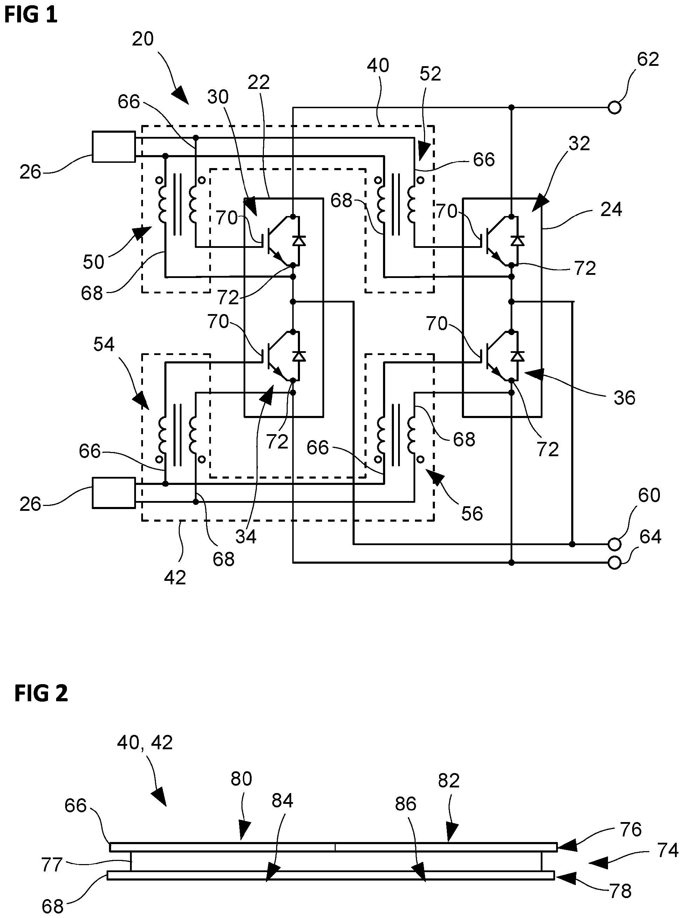

Fig. 1 shows an electric circuit diagram of an exemplary embodiment of a semiconductor arrangement 20. The semiconductor arrangement 20 comprises at least one common mode choke, e.g., a first common mode choke 50, a second common mode choke 52, a third common mode choke 54, and a fourth common mode choke 56, and at least one semiconductor switch, e.g., a first semiconductor switch 30, a second semiconductor switch 32, a third semiconductor switch 34, and a fourth semiconductor switch 36. In an alternative embodiment, the semiconductor arrangement 20 may comprise less or more than four common mode chokes 50, 52, 54, 56 and/or less or more than four semiconductor switches 30, 32, 34, 36. The semiconductor switches 30, 32, 34, 36 may be IGBTs or MOSFATs, for example.

The semiconductor arrangement 20 may represent an electrical converter, e.g., an inverter or a rectifier. To this end, the semiconductor arrangement 20 may comprise an AC terminal 60, a first DC terminal 62, e.g., a DC+ terminal, and a second DC terminal 64, e.g., a DC- terminal.

The first semiconductor module 22 may be electrically coupled to the second semiconductor module 24 by the common mode chokes 50, 52, 54, 56. In particular, the first semiconductor switch 30 may be electrically coupled to the third semiconductor switch 34 by the first and second common mode chokes 50, 52 and the second semiconductor switch 32 may be electrically coupled to the fourth semiconductor switch 36 by the third and fourth common mode chokes 54, 56. Optionally, the first common mode choke 50 may be electrically arranged in series with the second common mode choke 52 between the first and second semiconductor switches 30, 32, and the third common mode choke 54 may be electrically arranged in series with the fourth common mode choke 56 between the third and fourth semiconductor switches 34, 36.

The semiconductor switches 30, 32, 34, 36 may be arranged in semiconductor modules, e.g., in a first semiconductor module 22 and a second semiconductor module 24. Each of the semiconductor modules 22, 24 has at least one of the semiconductor switches 30, 32, 34, 36. For example, the first and third semiconductor switches 30, 34 may be arranged in a first semiconductor module 22 and the second and fourth semiconductor switches 32, 36 may be arranged in a second semiconductor module 24. The semiconductor modules 22, 24 may be electrically arranged in parallel within the semiconductor arrangement 20, for example. Alternatively, the semiconductor modules 22, 24 may be electrically arranged in series. Each of the semiconductor switches 30, 32, 34, 36 may have a freewheeling diode between the emitter and the drain of the corresponding semiconductor switch 30, 32, 34, 36. The freewheeling diodes are electrically arranged anti parallel to the corresponding semiconductor switch 30, 32, 34, 36. The freewheeling diodes may allow a current to flow in backward direction through the corresponding semiconductor module 22, 24.

The semiconductor arrangement 20 may further have one or more gate drivers 26 for driving, in other words controlling, the semiconductor modules 22, 24, in particular the semiconductor switches 30, 32, 34, 36. In the embodiment of figure 1, one of the gate drivers 26 is configured for driving the first and second semiconductor switches 30, 32 and the other one of the gate drivers 26 is configured for driving the third and fourth semiconductor switches 34, 36.

The gate driver(s) 26 may be electrically coupled to the semiconductor switches 30, 32, 34, 36 by the common mode chokes 50, 52, 54, 56. In particular, one of the gate drivers 26 may be electrically coupled to the first semiconductor switch 30 by the first common mode choke 50 and to the second semiconductor switch 32 by the second common mode 52, and/or the other one of the gate drivers 26 may be electrically coupled to the third semiconductor switch 34 by the third common mode choke 54 and to the fourth semiconductor switch 36 by the fourth common mode choke 56. For example, the outputs of the gate drivers 26 may be electrically connected to gates and/or auxiliary emitters of the corresponding semiconductor switches 30, 32, 34, 36 of the corresponding semiconductor modules 22, 24 via the corresponding common mode chokes 50, 52, 54, 56.

Each of the semiconductor switches 30, 32, 34, 36 may have a corresponding first electrical contact 70 and at least a corresponding second electrical contact 72. The electrical contacts 70, 72 each may be one electrical contact out of a group of electrical contacts, the group having gate contacts, drain contacts, source contacts, and auxiliary emitter contacts. In the embodiment of figure 1, the first electrical contacts 70 may be the gate contacts and the second electrical contacts 72 may be the auxiliary emitter contacts of the semiconductor switches 30, 32, 34, 36, for example.

In particular, the first semiconductor switch 30 may have a first electrical contact 70, e.g., a gate of the first semiconductor switch 30, and a second electrical contact 72, e.g., an auxiliary emitter of the first semiconductor switch 30. The second semiconductor switch 32 may have a first electrical contact 70, e.g., a gate of the second semiconductor switch 32, and a second electrical contact 72, e.g., an auxiliary emitter of the second semiconductor switch 32. The third semiconductor switch 34 may have a first electrical contact 70, e.g., a gate of the third semiconductor switch 34, and a second electrical contact 72, e.g., an auxiliary emitter of the third semiconductor switch 34. The fourth semiconductor switch 36 may have a first electrical contact 70, e.g., a gate of the fourth semiconductor switch 36, and a second electrical contact 72, e.g., an auxiliary emitter of the fourth semiconductor switch 36.

Each of the common mode chokes 50, 52, 54, 56 has an electrically conductive first conductor path 66 and an electrically conductive second conductor path 68. Each of the conductor paths 66, 68 forms at least two coils 80, 82, 84, 86, wherein each conductor path 66, 68 has a clockwise orientation in a section of at least one of its coils 80, 82, 84, 86, and the same conductor path 66, 68 has a counter-clockwise orientation in a section of the other one of its coils 80, 82, 84, 86, as explained in more detail further below. Each of the conductor paths 66, 68 may be embodied as electrically conductive line or via.

The first conductor path 66 of the first common mode choke 50 may be electrically coupled to the first conductor path 66 of the second common mode choke 52. The second conductor path 68 of the first common mode choke 50 may be electrically coupled to the second conductor path 68 of the second common mode choke 52. The first conductor path 66 of the third common mode choke 54 may be electrically coupled to the first conductor path 66 of the fourth common mode choke 56. The second conductor path 68 of the third common mode choke 54 may be electrically coupled to the second conductor path 68 of the fourth common mode choke 56.

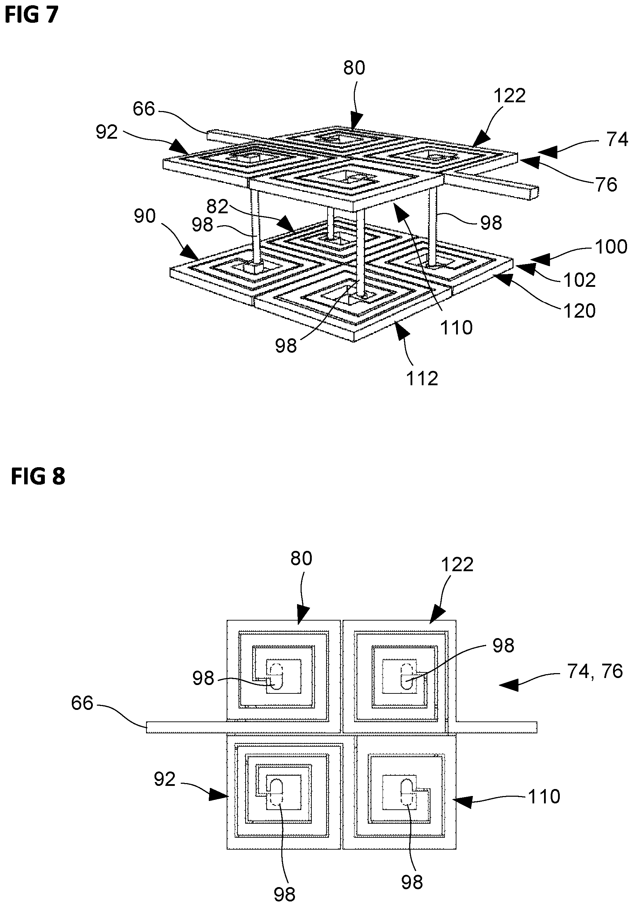

In each of the common mode chokes 50, 52, 54, 56, the corresponding second conductor path 68 is electrically isolated against the corresponding first conductor path 66 and follows the corresponding first conductor path 66. That the second conductor path 68 "follows" the first conductor path 66 may mean that the conductor paths 66, 68 of the same common mode choke 50, 52, 54, 56 are parallel to each other, in particular over their whole length within the corresponding common mode choke 50, 52, 54, 56. That the conductor paths 66, 68 are parallel to each other may mean that a distance between the conductor paths 66, 68 stays the same, e.g., over the lengths of the whole conductor paths 66, 68 within the corresponding common mode choke 50, 52, 54, 56. Alternatively or additionally, that the second conductor path 68 "follows" the corresponding first conductor path 66 may mean that a structure and/or form of the second conductor path 68 corresponds to a structure and/or, respectively, form of the corresponding first conductor path 66. Alternatively or additionally, that the second conductor path 68 "follows" the first conductor path 66 may mean that from a top view on the corresponding PCB 40, 42 the second conductor path 68 is nearly completely covered by the corresponding first conductor path 66, e.g., as may be seen from figures 8 to 10, and/or that from a top view on the conductor paths 66, 68 the form and/or structure of the conductor paths 66, 68 are the same, or at least basically the same. That the second conductor path 68 is "nearly completely" covered by the first conductor path 66 from a top view may mean that, when seen from the top view, the first conductor path 66 overlaps the second conductor path 68 such that more than 80%, e.g., more than 90%, e.g., more than 95% of the whole area of the second conductor path 68 is overlapped by the first conductor path 66, at least in the region of the coils 80, 82, 84, 86.

The first semiconductor module 22 may be electrically coupled to the second semiconductor module 24 via the first and second common mode chokes 50, 52 by the first electrical contact 70 of the first semiconductor switch 30 being electrically coupled to the first electrical contact 70 of the second semiconductor switch 32 via the first conductor paths 66 of the first and second common mode chokes 50, 52, and the second electrical contact 72 of the first semiconductor switch 30 may be electrically coupled to the second electrical contact 72 of the second semiconductor switch 32 via the second conductor paths 68 of the first and second common mode chokes 50, 52.

In addition, the first semiconductor module 22 may be electrically coupled to the second semiconductor module 24 via the third and fourth common mode chokes 54, 56 by the first electrical contact 70 of the third semiconductor switch 34 being electrically coupled to the first electrical contact 70 of the fourth semiconductor switch 36 via the first conductor paths 66 of the third and fourth common mode chokes 54, 56, and the second electrical contact 72 of the third semiconductor switch 34 may be electrically coupled to the second electrical contact 72 of the fourth semiconductor switch 36 via the second conductor paths 68 of the third and fourth common mode chokes 54, 56.

The gate driver(s) 26 may be electrically coupled with the corresponding semiconductor switches 30, 32, 34, 36 via the conductor paths 66, 68 of the corresponding common mode chokes 50, 52, 54, 56 being electrically coupled to the electrical contacts, e.g., the first electrical contacts 70, i.e., the gates, of the corresponding semiconductor switches 30, 32, 34, 36. For example, one of the gate drivers 26 may be electrically coupled to the first electrical contact 70 of the first semiconductor switch 30 via the first conductor path 66 of the first common mode choke 50 and to the second electrical contact 72 of the first semiconductor switch 30 via the second conductor path 68 of the first common mode choke 50. The same gate driver 26 may be electrically coupled to the first electrical contact 70 of the second semiconductor switch 32 via the first conductor path 66 of the second common mode choke 52 and to the second electrical contact 72 of the second semiconductor switch 32 via the second conductor path 68 of the second common mode choke 52.

The other one of the gate drivers 26 may be electrically coupled to the first electrical contact 70 of the third semiconductor switch 34 via the first conductor path 66 of the third common mode choke 54 and to the second electrical contact 72 of the third semiconductor switch 34 via the second conductor path 68 of the third common mode choke 54. The same gate driver 26 may be electrically coupled to the first electrical contact 70 of the fourth semiconductor switch 36 via the first conductor path 66 of the fourth common mode choke 56 and to the second electrical contact 72 of the fourth semiconductor switch 36 via the second conductor path 68 of the fourth common mode choke 56.

Each of the common mode chokes 54, 56 is formed and/or arranged on a Printed Circuit Board (PCB). The PCB may be an adapter board or may be a component of the adapter board of the semiconductor arrangement 20. The adapter board may be used to couple one or more of the semiconductor switches 30, 32, 34, 36 to each other and/or to one or more corresponding gate drivers 26. For example, the first and second common mode chokes 50, 52 may be formed and/or arranged on or within a first PCB 40. The first PCB 40 may be referred to as first adapter board. The third and fourth common mode chokes 54, 56 may be formed and/or arranged on or within a second PCB 42. The second PCB 42 may be referred to as second adapter board. Optionally, the first to fourth common mode chokes 50, 52, 54, 56 may be arranged on one single adapter board only. Alternatively, a separate adapter board for each of the common mode chokes 50, 52, 54, 56 may be provided. The conductor paths 66, 68 each may be embedded within the corresponding PCB 40, 42 or may be arranged and/or formed, e.g., printed, on the corresponding PCB 40, 42.

Fig. 2 shows a side view of a first level 74 of an exemplary embodiment of one of the PCBs 40, 42 of the semiconductor arrangement 20 of figure 1. The PCB 40, 42 may have a first level 74. The first level 74 may have a first insulation layer 77, a first conductive layer 76 on top of the insulation layer 77, and at least a second conductive layer 78 underneath the first insulation layer 77. In case of the PCBs 40, 42 being oriented horizontally, as shown in figure 2, the first conductive layer 76 is facing upwards, whereas the second conductive layer 78 is facing downwards. In this context, the first conductive layer 76 may be referred to as outer layer of the PCBs 40, 42 and the second conductive layer 78 may be referred to as inner layer of the PCBs 40, 42. In this context it has to be mentioned with respect to the orientation of the PCBs 40, 42, that it is always assumed in the present description and the attached claims that a first main plain of each of the PCBs 40, 42 is always oriented horizontally such that the first main plains are facing upwards. Similarly, a second main plain of each of the PCBs 40, 42 opposite the corresponding first main plains is also always oriented horizontally, wherein the second main plains are facing downwards.

As may be seen from figure 2, the first conductor paths 66 are formed by the first conductive layer 76 of the first level 74, whereas the second conductor paths 68 are formed by the second conductive layer 78 of the first level 74.

Each of the conductor paths 66, 68 has at least two coils. For example, each of the first conductor paths 66 has a first coil 80 and a second coil 82 of the corresponding first conductor path 66, and each of the second conductor paths 68 has a first coil 84 and a second coil 86 of the corresponding second conductor path 68. The first and second coils 80, 82, 84, 86 of each of the conductor paths 66, 68 are formed within the first level 74. For example, the first and second coils 80, 82 of the first conductor paths 66 may be formed by the first conductive layers 76 of the corresponding first levels 74, and the first and second coils 84, 86 of the second conductor paths 68 may be formed by the second conductive layers 78 of the corresponding first level 74.

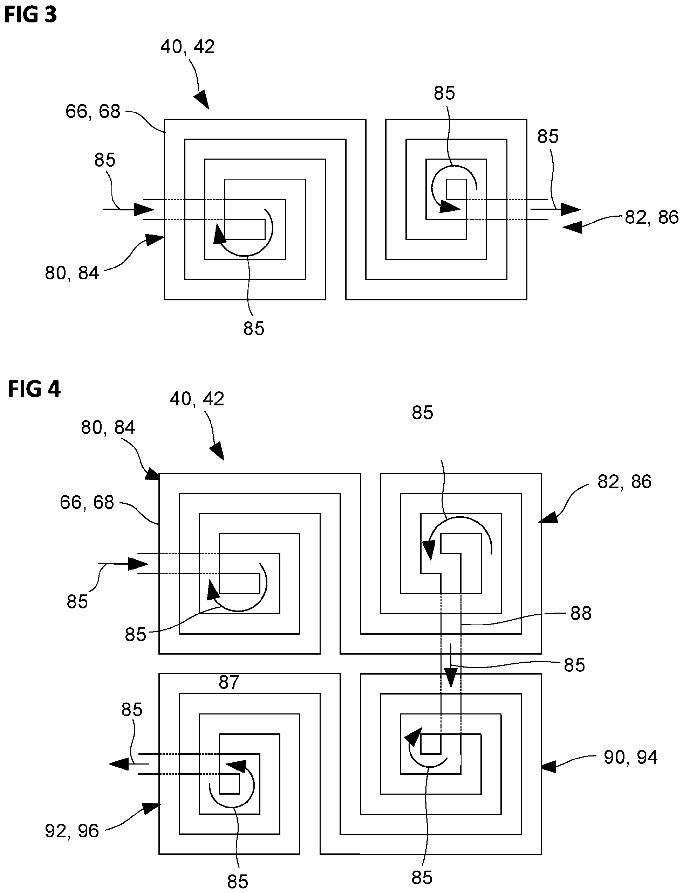

Fig. 3 shows a top view on two coils 80, 82, 84, 86 of an exemplary embodiment of one of the conductor paths 66, 68 of the semiconductor arrangement 20 of figure 1. The conductor paths 66, 68 may correspond to the conductor paths 66, 68 described with respect to figure 2. The conductor paths 66, 68 each may have its first and second coils 80, 82, 84, 86, wherein the conductor paths 66, 68 are oriented differently in the first coils 80, 84 than they are in the second coils 82, 86. For example, in figure 3, when the current flows in a current flow direction 85 from the first coils 80, 84 to the second coils 82, 86, the current flow direction 85 and thereby the orientation of the conductor paths 66, 68 is clockwise in the first coils 80, 84, and the current flow direction 85 and thereby the orientation of the conductor paths 66, 68 is counterclockwise in a region of the second coils 82, 86.

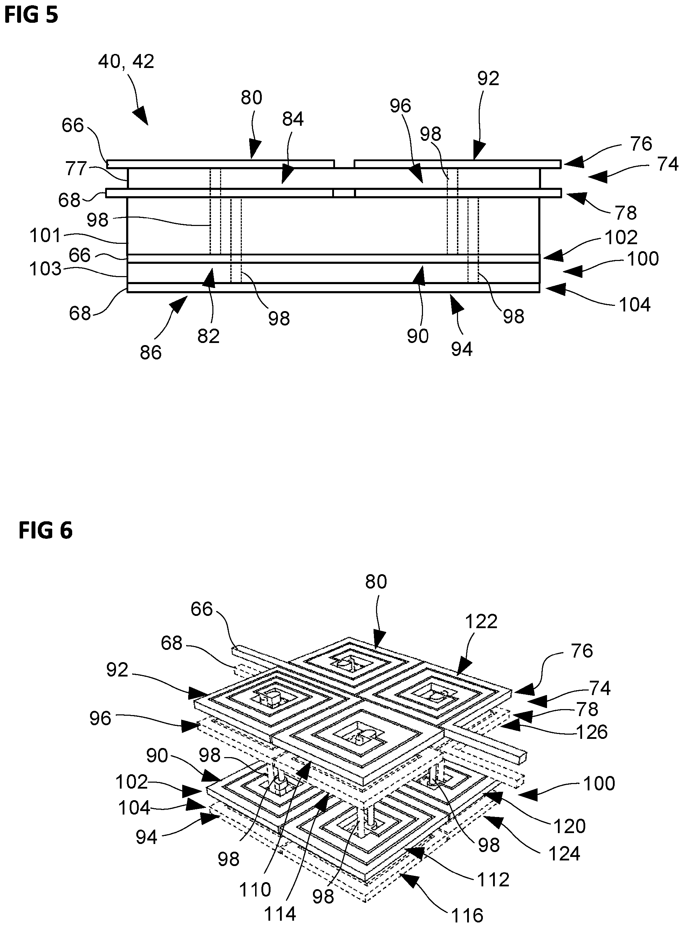

When both conductor paths 66, 68 are arranged underneath the each other, as shown in figure 2, the second conductor path 68 may be nearly completely covered by the first conductor path 66 - except for some connection bars 98 (see figures 5 to 7) - when seen in a top view, as it is given by figure 3, such that nearly the whole second conductor path 68 is not visible, because it follows the first conductor path 66 and has the same structure, in particular the same course, width and length, as the first conductor path 66.

Fig. 4 shows a top view on four coils 80, 82, 84, 86, 90, 92, 94, 96 of an exemplary embodiment of the conductor paths 66, 68 of the semiconductor arrangement 20 of figure 1. The conductor paths 66, 68 may correspond to the conductor paths 66, 68 described with respect to figure 2. For example, the four coils 80, 82, 84, 86, 90, 92, 94, 96 all may be formed within the first level 74 of the corresponding PCB 40, 42. The first conductor path 66 may have the first and second coils 80, 82 and a third and fourth coil 90, 92 of the first conductor path 66. The second conductor path 68 may have the first and second coils 84, 86 and a third and fourth coil 94, 96 of the second conductor path 68 of the corresponding PCB 40, 42. The four coils 80, 82, 90, 92 of the first conductor path 66 may be formed by the first conductive layer 76 of the first level 74 and the four coils 84, 86, 94, 96 of the second conductor path 68 may be formed by the second conductive layer 78 of the first level 74 of the corresponding PCB 40, 42.

The second coils 82, 86 of the conductor paths 66, 86 each may be electrically coupled to the third coils 90, 94 of the same conductor path 66, 68 via a corresponding connection path 88.

In case of each of the conductor paths 66, 68 comprising four coils 80, 82, 84, 86, 90, 92, 94, 96 in one level 74, these four coils 80, 82, 84, 86, 90, 92, 94, 96 may be arranged in form of a 2x2 matrix, as may be seen from figure 4. The conductor paths 66, 68 through the coils 80, 82, 84, 86, 90, 92, 94, 96 in form of the 2x2 matrix arranged on the same diagonal within the matrix may have the same orientation, as depicted in figure 4. For example, the current flow direction 85 within the first and third coils 80, 84, 90, 94 may be clockwise, whereas the current flow direction 85 within the second and fourth coils 82, 86, 92, 96 may be counterclockwise. Correspondingly, the current paths 66, 68 within the first and third coils 80, 84, 90, 94 may be clockwise, whereas the current paths 66, 68 within the second and fourth coils 82, 86, 92, 96 may be counterclockwise.

When both conductor paths 66, 68 are arranged underneath each other, as shown in figure 2, the second conductor path 68 may be nearly completely covered by the first conductor path 66 when seen in a top view, as it is given by figure 4, such that the second conductor path 68 is not visible, because it follows the first conductor path 66 and has the same structure, in particular the same course, width and length, as the first conductor path 66.

Fig. 5 shows a side view of the first level 74 and of a second level 100 of an exemplary embodiment of one of the PCBs 40, 42 of the semiconductor arrangement 20 of figure 1. Each of the conductor paths 66, 68 forms at least four coils 80, 82, 84, 86, 90, 92, 94, 96. The second level 100 is arranged underneath the first level 74. The second level 100 may be electrically insulated against the first level 74 by a second insulation layer 101 of the corresponding PCB 40, 42. The second level 100 may comprise a first conductive layer 102 of the second level 100 and a second conductive layer 104 of the second level 100. The first conductor path 66 may be formed by the first layers 76, 102 of the first and second levels 74, 100, and the second conductor path 68 may be formed by the second layers 78, 104 of the first and second level 74, 100. So, each of the conductor paths 66, 68 may extend over two different levels 74, 100 of the same PCB 40, 42.

For example, two of the four coils 80, 84, 92, 96 of one of the conductor paths 66, 68 are formed within the first level 74, and the other two coils 82, 86, 90, 94 of the same conductor path 66, 68 may be formed within the second level 100. The first coil 80 of the first conductor path 66 being arranged in the first level 74 and second coil 82 of the first conductor path 66 being arranged in the second level 100 may be electrically coupled to each other via a connection bar 98. The first coil 84 of the second conductor path 68 being arranged in the first level 74 and second coil 86 of the second conductor path 68 being arranged in the second level 100 may be electrically coupled to each other via another connection bar 98. The third coil 90 of the first conductor path 66 being arranged in the second level 100 and the fourth coil 92 of the first conductor path 66 being arranged in the first level 74 may be electrically coupled to each other via another connection bar 98. The third coil 94 of the second conductor path 68 being arranged in the second level 100 and the fourth coil 96 of the second conductor path 68 being arranged in the first level 74 may be electrically coupled to each other via another connection bar 98.

The conductor paths 66, 68 and thereby the current flow direction 85 in two coils 80, 82, 84, 86, 90, 92, 94, 96, 110, 112, 114, 116, 120, 122, 124, 126 of the same conductor path 66, 68 being arranged underneath each other may have the same orientation.

In case of each of the conductor paths 66, 68 having four coils 80, 82, 84, 86, 90, 92, 94, 96 only, the embodiment shown in figure 5 from a side view may be the same embodiment as shown in figure 3 from a top view. In case of each of the conductor paths 66, 68 having eight coils 80, 82, 84, 86, 90, 92, 94, 96, 110, 112, 114, 116, 120, 122, 124, 126, the embodiment shown in figure 5 from a side view may be the same embodiment as shown in figure 6 from a perspective view.

Fig. 6 shows a perspective view of an exemplary embodiment of the two conductor paths 66, 68 of the semiconductor arrangement 20 of figure 1, wherein the second conductor path 68 is depicted by dashed lines. Each of the conductor paths 66, 68 forms at least eight coils 80, 82, 84, 86, 90, 92, 94, 96, 110, 112, 114, 116, 120, 122, 124, 126. For example, four coils 80, 84, 92, 96, 110, 114, 122, 126 of one of the conductor paths 66, 68 are formed within the first level 74, and the other four coils 82, 86, 90, 94, 112, 116, 120, 124 of the same conductor path 66, 68 are formed within the second level 100.

For example, the four coils 80, 92, 110, 122 of the first conductor path 66 being arranged within the first level 74 may be formed by within the first conductive layer 76 of the first level 74, and the four coils 82, 90, 112, 120 of the first conductor path 66 being arranged within the second level 100 may be formed by the first conductive layer 102 of the second level 100. Similarly, the four coils 84, 96, 114, 126 of the second conductor path 68 being arranged within the first level 74 may be formed by the second conductive layer 78 of the first level 74, and the four coils 86, 94, 116, 124 of the second conductor path 68 being arranged within the second level 100 may be formed by the second conductive layer 104 of the second level 100.

A detailed course of the first and/or second conductor paths 66, 68 is explained in more detail with respect to figure 7.

Fig. 7 shows a perspective view of one of the conductor paths 66, 68 of figure 6 only, e.g., of the first conductor path 66. However, the second conductor path 68 may have basically the same structure, because the second conductor path 68 always follows the first conductor path 66. The first conductor path 66 is formed and/or arranged such that it changes the level 74, 100 of the corresponding PCB 40, 42 after the first coil 80 and then after every second one of the coils 82, 90, 92, 110, 112, 120. In particular, the first conductor path 66 changes from the first to the second level 74, 100 after the first coil 80, from the second to the first level 100, 74 after the third coil 90, from the first to the second level 74, 100 after the fifth coil 110, and from the second to the first level 100, 74 after the seventh coil 120.

As can be seen from figure 7, two of the coils 80, 82, 90, 92, 110, 112, 120, 122 being electrically arranged behind each other and being arranged within the same level 74, 100 may be directly coupled to each other by the first conductor path 66 extending from one of these coils 80, 82, 90, 92, 110, 112, 120, 122 to the next of these coils 80, 82, 90, 92, 110, 112, 120, 122 within the same level 74, 100. In contrast, two of the coils 80, 82, 90, 92, 110, 112, 120, 122 being electrically arranged behind each other and being arranged within another one of the levels 74, 100 may be coupled to each other by the corresponding connection bars 98 extending from one of these coils 80, 82, 90, 92, 110, 112, 120, 122 to the next of these coils 80, 82, 90, 92, 110, 112, 120, 122 within the other level 74, 100.

The conductor paths 66, 68 and thereby the current flow direction 85 in two coils 80, 82, 84, 86, 90, 92, 94, 96, 110, 112, 114, 116, 120, 122, 124, 126 of the same conductor path 66, 68 being arranged underneath each other may have the same orientation. For example, the conductor paths 66, 68 within the first and second coils 80, 82, the third and fourth coils 90, 92, the fifth and sixth coils 110, 112, and the seventh and eight coils 120, 122 pairwise may have the same orientation. For example, the first conductor path 66 has a counterclockwise orientation in the region of the first and second coils 80, 82, a clockwise orientation in the region of the third and fourth coils 90, 92, a counterclockwise orientation in the region of the fifth and sixth coils 110, 112, and a clockwise orientation in the region of the seventh and eight coils 120, 122. Thus, as explained with respect to figure 4, the first conductor path 66 within the coils 80, 82, 90, 92, 110, 112, 120, 122 arranged on the same diagonal within the 2x2 matrix may have the same orientation. As already mentioned above, an orientation of the current paths 66, 68 as defined in this description always depends on the current flow direction 85 through the corresponding coil 80, 82, 84, 86, 90, 92, 94, 96, 110, 112, 114, 116, 120, 122, 124, 126 and may differ from the physical orientation of the coils 80, 82, 84, 86, 90, 92, 94, 96, 110, 112, 114, 116, 120, 122, 124, 126.

Fig. 8 shows a top view of an exemplary embodiment of conductor paths 66, 68 of the semiconductor arrangement 20 of figure 1. Figure 8 may also represent a top view of the embodiment shown in figure 7.

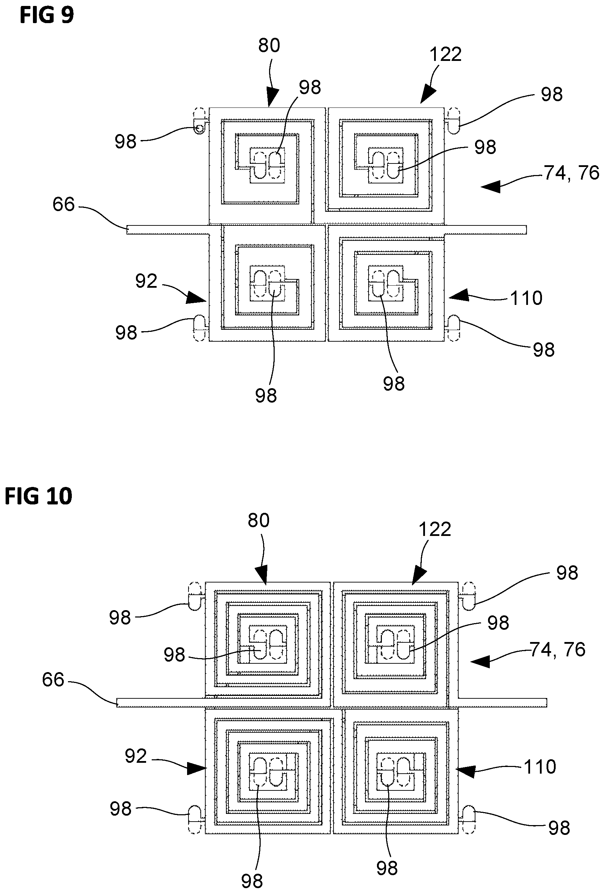

The width of each of the conductor paths 66, 68 and/or the number of windings of the corresponding coils 80, 82, 84, 86, 90, 92, 94, 96, 110, 112, 114, 116, 120, 122, 124, 126 may be altered, as shown with respect to figures 9 and 10 in comparison with figure 8.

Fig. 9 shows a top view of an exemplary embodiment of the conductor paths 66, 68 of the semiconductor arrangement 20 of figure 1, wherein the width of the conductor paths 66, 68 of figure 9 is larger than the width of the conductor paths 66, 68 of figure 8 and wherein each of the coils 80, 82, 84, 86, 90, 92, 94, 96, 110, 112, 114, 116, 120, 122, 124, 126 of figure 9 has less windings than the in figure 8.

Alternatively or additionally, the PCB 40, 42 by which the conductor paths 66, 68 are formed may have four levels 74, 100 (not shown) with each level 74, 100 having two conductive layers 76, 78, 102, 104 separated by corresponding insulation layers 77, 101, 103. In this embodiment, each of the conductor paths 66, 68 may have 16 coils 80, 82, 84, 86, 90, 92, 94, 96, 110, 112, 114, 116, 120, 122, 124, 126, with each four of these coils 80, 82, 84, 86, 90, 92, 94, 96, 110, 112, 114, 116, 120, 122, 124, 126 being arranged in the same level 74, 100. The conductor paths 66, 68 in different ones of these levels 74, 100 may be electrically coupled to each other via the connection bars 98, wherein some of these connection bars 98 may be arranged in the centres of the corresponding coils 80, 82, 84, 86, 90, 92, 94, 96, 110, 112, 114, 116, 120, 122, 124, 126 and some of these connection bars 98 may be arranged in the outsides, e.g., corners, of the corresponding coils 80, 82, 84, 86, 90, 92, 94, 96, 110, 112, 114, 116, 120, 122, 124, 126, as shown in figure 9.

Fig. 10 shows a top view of an exemplary embodiment of the conductor paths 66, 68 of the semiconductor arrangement 20 of figure 1, wherein the width of the conductor paths 66, 68 of figure 10 is smaller than the width of the conductor paths 66, 68 of figure 8 and wherein each of the coils 80, 82, 84, 86, 90, 92, 94, 96, 110, 112, 114, 116, 120, 122, 124, 126 of figure 10 has more windings than the coils 80, 82, 84, 86, 90, 92, 94, 96, 110, 112, 114, 116, 120, 122, 124, 126 shown in figure 8.

Alternatively or additionally, the PCB 40, 42 by which the conductor paths 66, 68 are formed may have four levels 74, 100 with each level 74, 100 having two conductive layers 76, 78, 102, 104 separated by corresponding insulation layers 77, 101, 103, as explained above with respect to figure 9.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

| | |
|---|---|
| Semiconductor arrangement | 20 |
| First semiconductor module | 22 |
| Second semiconductor module | 24 |
| Gate driver | 26 |
| First semiconductor switch | 30 |
| Second semiconductor switch | 32 |
| Third semiconductor switch | 34 |
| Fourth semiconductor switch | 36 |
| First printed circuit board | 40 |
| Second printed circuit board | 42 |
| First common mode choke | 50 |
| Second common mode choke | 52 |
| Third common mode choke | 54 |
| Fourth common mode choke | 56 |
| AC terminal | 60 |
| First DC terminal | 62 |
| Second DC terminal | 64 |
| First conductor path | 66 |
| Second conductor path | 68 |
| First electrical contact | 70 |
| Second electrical contact | 72 |
| First level | 74 |
| First conductive layer of first level | 76 |
| First insulation layer | 77 |
| Second conductive layer of first level | 78 |
| First coil of first conductor path | 80 |
| Second coil of first conductor path | 82 |
| First coil of second conductor path | 84 |
| Current flow direction | 85 |
| Second coil of second conductor path | 86 |
| Connection path | 88 |
| Third coil of first conductor path | 90 |
| Fourth coil of first conductor path | 92 |
| Third coil of second conductor path | 94 |
| Fourth coil of second conductor path | 96 |
| Connection bar | 98 |
| Second level | 100 |
| Second insulation layer | 101 |
| First conductive layer of second level | 102 |
| Third insulation layer | 103 |
| Second conductive layer of second level | 104 |
| Fifth coil of first conductor path | 110 |
| Sixth coil of first conductor path | 112 |
| Fifth coil of second conductor path | 114 |
| Sixth coil of second conductor path | 116 |
| Seventh coil of first conductor path | 120 |
| Eight coil of first conductor path | 122 |
| Seventh coil of second conductor path | 124 |
| Eight coil of second conductor path | 126 |

## Claims

1. A common mode choke (50, 52, 54, 56), comprising:
a printed circuit board (40, 42);
a first conductor path (66) on or within the printed circuit board (40, 42); and
a second conductor path (68) on or within the printed circuit board (40, 42) underneath the first conductor path (66), wherein
the second conductor path (68) is electrically isolated against the first conductor path (66),
the second conductor path (68) follows the first conductor path (66),
each of the conductor paths (66, 68) forms at least two coils (80, 82, 84, 86), and
each conductor path (66, 68) has a clockwise orientation in at least one of its coils (80, 82, 84, 86), and the same conductor path (66, 68) has a counter-clockwise orientation in the other one of its coils (80, 82, 84, 86).

2. The common mode choke (50, 52, 54, 56) according to claim 1, wherein
the printed circuit board (40, 42) comprises at least a first level (74), and
the two coils (80, 82, 84, 86) of each of the conductor paths (66, 68) are formed within the first level (74).

3. The common mode choke (50, 52, 54, 56) according to claim 2, wherein
the first level (74) comprises a first conductive layer (76) and at least a second conductive layer (78) arranged underneath the first conductive layer (76),
the first conductor path (66) is formed by the first conductive layer (76) of the first level (74), and
the second conductor path (68) is formed by the second conductive layer (78) of the first level (74).

4. The common mode choke (50, 52, 54, 56) according to one of claims 2 or 3, wherein
each conductor path (66, 68) forms at least four coils (80, 82, 84, 86), and
the four coils (80, 82, 84, 86) of the conductor paths (66, 68) are formed within the first level (74).

5. The common mode choke (50, 52, 54, 56) according to claim 3, wherein
each conductor path (66, 68) forms at least four coils (80, 82, 84, 86, 90, 92, 94, 96),
the printed circuit board (40, 42) comprises at least a second level (100) underneath the first level (74),
two of the four coils (80, 82, 84, 86, 90, 92, 94, 96) of one of the conductor paths (66, 68) are formed within the first level (74), and
the other two coils (80, 82, 84, 86, 90, 92, 94, 96) of the same conductor path (66, 68) are formed within the second level (100).

6. The common mode choke (50, 52, 54, 56) according to claim 5, wherein
each conductor path (66, 68) forms at least eight coils (80, 82, 84, 86, 90, 92, 94, 96, 110, 112, 114, 116, 120, 122, 124, 126),
four coils (80, 82, 84, 86, 90, 92, 94, 96, 110, 112, 114, 116, 120, 122, 124, 126) of one of the conductor paths (66, 68) are formed within the first level (74), and
the other four coils (80, 82, 84, 86, 90, 92, 94, 96, 110, 112, 114, 116, 120, 122, 124, 126) of the same conductor path (66, 68) are formed within the second level (100).

7. The common mode choke (50, 52, 54, 56) according to one of claims 4 to 6, wherein in case of each of the conductor paths (66, 68) comprising four coils (80, 82, 84, 86, 90, 92, 94, 96, 110, 112, 114, 116, 120, 122, 124, 126) in one level (74, 100), these four coils (80, 82, 84, 86, 90, 92, 94, 96, 110, 112, 114, 116, 120, 122, 124, 126) are arranged in form of a 2x2 matrix, wherein the conductor paths (66, 69) in the coils (80, 82, 84, 86, 90, 92, 94, 96, 110, 112, 114, 116, 120, 122, 124, 126) arranged on the same diagonal have the same orientation

8. The common mode choke (50, 52, 54, 56) according to one of claims 5 to 7, wherein
the conductor paths (66, 68) are formed and/or arranged such that each of the conductor paths (66, 68) changes the level (74, 100) of the printed circuit board (40, 42) after the first coil (80, 84) and then after every second one of the coils (90, 94, 110, 114, 120, 124).

9. The common mode choke (50, 52, 54, 56) according to claim 8, wherein
the conductor paths (66, 68) have the same orientation in two of their coils (80, 82, 84, 86, 90, 92, 94, 96, 110, 112, 114, 116, 120, 122, 124, 126) being arranged underneath each other.

10. Semiconductor arrangement (20), comprising:
at least one common mode choke (50, 52) according to one of the preceding claims;
a first semiconductor switch (30) having a first electrical contact (70) and at least a second electrical contact (72) of the first semiconductor switch (30), wherein the first conductor path (66) of the common mode choke (50, 52) is electrically coupled to the first electrical contact (70) of the first semiconductor switch (30) and the second conductor path (68) of the common mode choke (50, 52) is electrically coupled to the second electrical contact (72) of the first semiconductor switch (30); and
at least a second semiconductor switch (32) having a first electrical contact (70) and at least a second electrical contact (72) of the second semiconductor switch (32), wherein the first conductor path (66) of the common mode choke (50, 52) is electrically coupled to the first electrical contact (70) of the second semiconductor switch (32) and thereby electrically couples the first electrical contact (70) of the first semiconductor switch (30) with the first electrical contact (70) of the second semiconductor switch (32), and wherein the second conductor path (68) of the common mode choke (50, 52) is electrically coupled to the second electrical contact (72) of the first semiconductor switch (30) and thereby electrically couples the second electrical contact (72) of the first semiconductor switch (30) with the second electrical contact (72) of the second semiconductor switch (32).

11. Semiconductor arrangement (20) in accordance with claim 10, comprising:
at least one gate driver (26) for driving the first semiconductor switch (30), wherein the gate driver (26) is electrically coupled with the first and/or second semiconductor switches (30, 32) by the common mode choke (50, 52).

12. Semiconductor arrangement (20) in accordance with one of claims 10 or 11, comprising:
a first semiconductor module (22) having the first semiconductor switch (30) and a third semiconductor switch (34); and
a second semiconductor module (24) having the second semiconductor switch (32) and a fourth semiconductor switch (36), wherein the third semiconductor switch (34) is electrically coupled to the fourth semiconductor switch (36) by another common mode choke (54, 56) in accordance with one of claims 1 to 9.
